# EUROPÄISCHE PATENTSCHRIFT

(11) **EP 1 305 821 B1**
(45) Veröffentlichungstag und Bekanntmachung des Hinweises auf die Patenterteilung: **08.10.2008**
(21) Anmeldenummer: 01960593.0
(22) Anmeldetag: 30.07.2001
(51) Int. Cl.: H01L 21/00, H01L 21/68

(54) **MOBILER HALTER FÜR EINEN WAFER**
MOBILE HOLDER FOR A WAFER
SUPPORT MOBILE POUR UNE PLAQUETTE

(30) Priorität: 02.08.2000 DE 10038052
(43) Veröffentlichungstag der Anmeldung: 02.05.2003
(73) Patentinhaber: Fraunhofer-Gesellschaft zur Förderung der angewandten Forschung e.V., 80686 München (DE)
(72) Erfinder: LANDESBERGER, Christof, 81241 München (DE); BLEIER, Martin, 80636 München (DE); KLUMPP, Armin, 80337 München (DE)
(74) Vertreter: Schoppe, Fritz
(86) Internationale Anmeldenummer: PCT/EP2001/008822
(87) Internationale Veröffentlichungsnummer: WO 2002/011184

(56) Entgegenhaltungen:
- EP-A- 0 506 537
- EP-A- 0 552 877
- US-A- 4 733 632

## Beschreibung

Die vorliegende Erfindung bezieht sich auf das Gebiet von Haltevorrichtungen für Wafer und insbesondere auf das Gebiet von elektrostatischen Haltevorrichtungen für Wafer.

Bei der Herstellung vieler Halbleiterbauelemente stellt die Handhabung eines Wafers einen bedeutenden Faktor für einen erfolgreichen Herstellungsprozess dar. Beispielsweise erfordert die Herstellung von Chipkarten und dünnen integrierten Schaltungen eine Handhabung von sehr dünnen Wafern, die ohne die Gefahr eines Brechens transportiert und gehalten werden müssen.

Bei vielen Halbleiterprozessen, wie beispielsweise der Herstellung von Schaltungselementen für die Leistungselektronik sind ferner Rückseitenprozesse notwendig, die ein Abscheiden von Lot- oder Legierungsschichten auf der Rückseite des fertig prozessierten Schaltungswafers umfassen, wobei einem anschließenden Legieren oder Sintern der Schichten hohe Temperaturen auftreten, die 400°C übersteigen können. Dabei muß die Haltevorrichtung für den Wafer ein einwandfreies Funktionieren bei diesen Umgebungstemperaturen sicherstellen.

Ein bekanntes Verfahren zur Handhabung dünner Wafer besteht darin, den Wafer auf der Vorderseite mit einer Schutzfolie, die typischerweise eine Polymerfolie ist, zu versehen. Der Wafer wird von der Trägerfolie während dem Durchlaufen der Dünnungssequenz gehalten. Die Einsatzmöglichkeit dieses bekannten Verfahrens umfaßt Wafer mit einem Durchmesser von 6 Zoll und mit einer Dicke bis maximal etwa 100 µm. Die Handhabung und der Transport von Wafern mit einer Dicke, die geringer als 100 µm liegt, wird durch die auftretende Verbiegung derselben verhindert, wodurch das Bruchrisiko für den dünnen Wafer stark ansteigt. Das Verfahren bietet folglich keine Perspektive, extrem dünne Wafer mit größeren Durchmessern zu handhaben.

Ein weiteres Verfahren verwendet einen Trägerwafer, auf den der zu dünnende Wafer mit einer beidseitig klebenden Folie, beispielsweise einer thermisch ablösbaren Folie, reversibel geklebt wird. Die thermisch lösbare Folie kann dabei durch ein Beaufschlagen einer Temperatur abgelöst werden. Das Verfahren bietet eine Einsatzmöglichkeit für Wafer mit einer Dicke von bis zu 20 µm, wobei auch Wafer mit einem großen Durchmesser sicher gehalten werden können. Das Verfahren weist jedoch den Nachteil auf, daß aufgrund der verwendeten klebenden Folie, die typischerweise eine Polymerfolie ist, das Verfahren für Rückseitenprozesse mit Temperaturen über 130°C nicht geeignet ist.

Ferner sind elektrostatische Haltevorrichtungen, sogenannte elektrostatische Chucks bekannt, um Wafer mittels elektrostatisch erzeugter Haltekräfte aufzunehmen und während eines Herstellungsprozesses zu halten. Die Erzeugung der Haltekraft kann mit einer monopolaren Elektrode oder mit bipolaren Elektroden erfolgen. In dem Fall einer monopolaren Elektrode dient der zu haltende Wafer als eine Gegenelektrode und muß folglich eine Masse-Verbindung aufweisen, die beispielsweise während eines Trockenätzprozesses durch das leitfähige Ätzplasma erreicht wird.

Die bekannten elektrostatischen Haltevorrichtungen weisen jedoch den Nachteil auf, daß dieselben massiv ausgebildet sind und typischerweise in einer Verarbeitungskammer fest installiert sind. Ferner sind die bekannten elektrostatischen Haltevorrichtungen von einer externen Leistungsversorgung abhängig. Folglich können die bekannten elektrostatischen Haltevorrichtungen lediglich als eine Haltevorrichtung zum Halten des Wafers an einem Ort und nicht zum Transportieren verwendet werden, um beispielsweise einen gedünnten Wafer an dem Ort der Durchführung der Dünnungssequenz aufzunehmen und an einen zweiten Ort, an dem beispielsweise eine Rückseitenbearbeitung durchgeführt wird, zu transportieren.

Folglich stellt die Handhabung von dünnen Wafern bei denen Verarbeitungsschritte mit hoher Temperatur, wie beispielsweise ein Sintern oder Legieren notwendig sind, ein Problem dar, da keine Vorrichtungen zur Handhabung derselben verfügbar sind.

Ferner ist derzeit keine Trägervorrichtung verfügbar, die ein Aufnehmen und ein selektives Ablösen von Chips ermöglicht, die einem Vereinzelungsverfahren, wie es beispielsweise in der DE-19962763 A1 beschrieben ist, unterworfen wurden.

Die EP 0 552 877 A1 offenbart einen elektrostatischen Chuck und ein Verfahren zum Erregen desselben. Der elektrostatische Chuck ist Teil eines Mehrkammersystems zum Prozessieren von integrierten Schaltungen. Eine Wafertransportplatte trägt einen Wafer mittels einer elektrostatischen Halteeinrichtung. Die Wafertransportplatte ist selbst über ein vier-Balken-Verbindungsgelenk mit einer Basis des Mehrkammersystems verbunden, derart, daß der Wafer durch Verschieben und Drehen der waferträgerplatte zwischen verschiedenen Kammern hin- und herbewegt werden kann. Die elektrostatische Halteeinrichtung umfaßt eine dielektrische Basisschicht, auf der Elektrodenstreifen angeordnet sind, die in einer dielektrischen Kapselschicht eingebracht sind. Die dielektrische Basisschicht ist auf der oberen Oberfläche der Waferträgerplatte unter Verwendung herkömmlicher Abscheidungs-, Maskierungs- und Ätzschritte gebildet.

Die EP 0 506 537 A1 offenbart einen elektrostatischen Chuck mit einer integralen fünfschichtigen Struktur, der zum Halten und Transportieren eines Halbleitersilizium-Wafers in einem Herstellungsprozess für elektronische Bauelemente geeignet ist. Der elektrostatische Chuck zeichnet sich besonders dadurch aus, daß der gehaltene Wafer unmittelbar freigegeben wird, wenn eine an Elektroden des Chucks angelegte Spannung abgeschaltet wird.

Die FR 2 774 807 offenbart einen Substratträger zum Halten eines Substrats, während derselbe einer Behandlung zugeführt wird. Insbesondere umfasst ein Substratträger aus Silizium zwei Elektroden aus dotiertem polykristallinen Silizium. Die beiden Elektroden sind durch eine Spule und einen Gleichrichter miteinander verbunden. Wird ein elektromagnetisches Feld an den Wafer angelegt, wird eine durchgehende Potentialdifferenz zwischen den zwei Elektroden aufgrund der Gleichrichtung und Integration aus Spule und Kapazität der Elektroden erzeugt.

Die JP 59132139 offenbart eine elektrostatische Chuck-Platte mit einer Elektrode, einer darauf angeordneten dielektrischen Schicht und dem zu tragenden Element. Als Dielektrikum wird ein Elektret verwendet, das eine Permanentpolarisation beibehält, oder ein Dielektrikum, bei dem ein Polarisationszustand erzeugt werden kann, und das den Polarisationszustand lange Zeit beibehält. Die Erzeugung findet beispielsweise durch eine Koronaentladung oder eine Gleichspannungskopplung statt. Ferner kann ein Dielektrikum verwendet werden, bei dem durch Bestrahlung mit Licht ein innerer Polarisationszustand erzeugt werden kann.

Die JP 9162272, gegenüber der des Patentanspruch 1 abgegrenzt ist offenbart einen elektrostatischen Halter, der auf einem Halteelement angebracht werden kann, ohne dass ein Haftmittel verwendet wird. Hierzu ist der elektrostatische Halter mit einer Platte ausgebildet, die eine obere Oberfläche aufweist, an der ein zu haltendes Element angezogen wird, und die ferner in einer Docking-Station ebenfalls durch elektrostatische Kräfte gehalten wird.

Die JP 5315429 offenbart eine zuverlässige Förderausrüstung, bei der es nicht nötig ist, ein stromführendes Kabel in einen langen Zuführkanal anzuordnen. Hierzu ist ein Träger mit einer einzigen Elektrode vorgesehen, während eine zweite Elektrode gewissermaßen der Wafer selbst ist. Ferner ist ein diskreter Kondensator vorgesehen, der an verschiedenen Positionen entlang des Zuführkanals aufgeladen werden kann, um den Wafer an dem Träger zu halten.

Die Aufgabe der vorliegenden Erfindung besteht darin, einen Halter für einer Wafer und ein Verfahren zum Handhaben eines Wafers zu schaffen.

Diese Aufgabe wird durch einem Halter nach Anspruch 1 und ein Verfahren nach Anspruch 14 gelöst.

Die vorliegende Erfindung basiert auf der Erkenntnis, daß ein Halter für einen Wafer geschaffen werden kann, indem eine erste Befestigungseinrichtung verwendet wird, um einen Wafer auf dem Halter anzubringen, während eine zweite Befestigungseinrichtung verwendet wird, um den Halter mit einem Träger für den mobilen Halter zu verbinden.

Ein Vorteil der vorliegenden Erfindung besteht darin, daß der Halter an einem beweglichen Träger angebracht werden kann, so daß der Halter mobil ist.

Ein weiterer Vorteil der vorliegenden Erfindung besteht darin, daß verschiedene Typen von Trägern für den mobilen Halter ohne weiteres verwendet werden können.

Ein bevorzugtes Ausführungsbeispiel der vorliegenden Erfindung umfaßt einen mobilen Halter mit einem flachen Basiselement, das einen kreisförmigen Siliziumwafer aufweist. Auf der Vorderseite des Basiselements ist eine isolierende Schicht gebildet, auf der wiederum eine erste Elektrode und eine zweite Elektrode ausgebildet sind, die zueinander beabstandet sind. Die isolierende Schicht ist aus einem elektrisch isolierenden Material wie beispielsweise Siliziumoxid gebildet. Die Elektroden weisen jeweils Anschlußbereiche auf, um ein Verbinden der Elektroden mit elektrischen Zuführungsleitungen zu ermöglichen. Der mobile Halter weist ferner eine funktionale Schicht auf, die über der ersten Elektrode und der zweiten Elektrode ganzflächig angeordnet ist und aus einem Material besteht, das bewegliche Ionen enthält. Die funktionale Schicht ermöglicht bei dem bevorzugten Ausführungsbeispiel, daß der mobile Halter einen aktiven Zustand aufweisen kann, ohne mit einer äußeren Spannungsquelle verbunden zu sein. Über der isolierenden Schicht ist eine Abdeckung aus einem isolierenden Material, wie beispielsweise Siliziumoxid, Silizium-Nitrid oder Silizium-Carbid als eine Schutzschicht ganzflächig gebildet.

Bei einem alternativen Ausführungsbeispiel umfaßt der mobile Halter eine aktive Schicht aus einem Material mit einer hohen Dielektrizitätskonstante.

Bei einem weiteren Ausführungsbeispiel weist der mobile Halter eine Matrix-Elektrodenstruktur auf, bei der einzelne Elektroden gezielt angesteuert und mit Spannungen versorgt werden können, um ein pixelweises Ablösen von Chips zu ermöglichen.

Ferner sind bei einem weiteren Ausführungsbeispiel Durchführungsleitungen für die erste Elektrode und zweite Elektrode durch das Basiselement durchgeführt, um ein Anschließen der Elektroden von der Rückseite des Basiselements zu ermöglichen.

Bei einem Ausführungsbeispiel stellt die zweite Befestigungseinrichtung die Fläche der Rückseite des mobilen Halters dar. Bei diesem Ausführungsbeispiel ist der Träger für den mobilen Halter ein herkömmlicher Vakuum-Wafer-Chuck, wobei der mobile Halter durch ein Vakuum, das zwischen der zweiten Befestigungseinrichtung und einer Befestigungsfläche des Wafer-Chucks angelegt wird, an dem Vakuum-Wafer-Chuck angebracht wird.

Bei einem weiteren Ausführungsbeispiel ist die zweite Befestigungseinrichtung ein Rand des mobilen Halters. Bei diesem Ausführungsbeispiel wird ein Anbringen des mobilen Halters an einem bekannten Träger dadurch erreicht, daß der Träger den mobilen Halter mechanisch an dem Rand greift.

Ferner ist bei einem noch weiteren Ausführungsbeispiel die Kante des mobilen Halters die zweite Befestigungseinrichtung, wobei ein bekannter Träger den mobilen Halter durch ein mechanisches Greifen des mobilen Halters an der Kante befestigt.

Weiterführende Ausbildungen der vorliegenden Erfindung sind in den abhängigen Patentansprüchen dargestellt.

Bevorzugte Ausführungsbeispiele der vorliegenden Erfindung werden nachfolgend unter Bezugnahme auf die beiliegenden Zeichnungen näher erläutert. Es zeigen:
- Fig. 1: eine Querschnittansicht eines mobilen Halters gemäß einem Ausführungsbeispiel der vorliegenden Erfindung; und
- Fig. 2: eine Draufsicht auf einen mobilen Halter gemäß einem Ausführungsbeispiel der vorliegenden Erfindung.

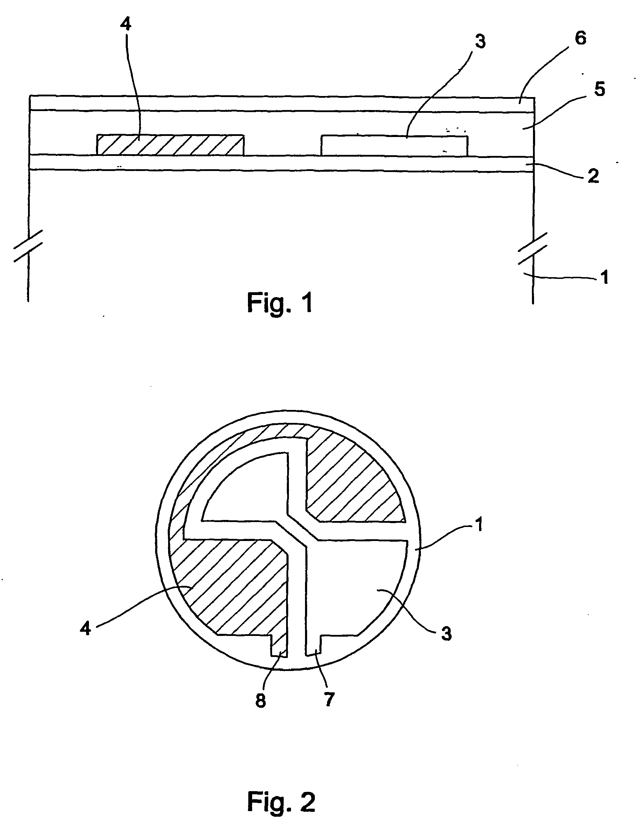

Gemäß Fig. 1 umfaßt ein mobiler Halter ein flaches, kreisförmiges Basiselement 1, auf dessen Vorderseite eine isolierende Schicht 2 gebildet ist. Die isolierende Schicht 2 ist aus einem elektrisch isolierenden Material wie beispielsweise Siliziumoxid oder Siliziumnitrid gebildet. Auf der isolierenden Schicht 2 sind eine erste Elektrode 3 und eine zweite Elektrode 4 beabstandet zueinander angeordnet. Vorzugsweise sind die erste Elektrode 3 und die zweite Elektrode 4 aus einem temperaturbeständigen elektrischen Leiter, wie beispielsweise einem Metall mit einer hohen Schmelztemperatur, gebildet und weisen gleiche Flächen auf, wie es unter Bezugnahme auf Fig. 2 nachfolgend erklärt wird.

Das Basiselement 1, das vorzugsweise aus einem Halbleitermaterial, Keramik wie beispielsweise AlO₂, Kapton oder SiC gebildet ist, weist einen Durchmesser auf, der gleich dem Durchmesser eines zu haltenden Wafers oder leicht größer als derselbe ist. Bei einem besonders bevorzugten Ausführungsbeispiel ist das Basiselement 1 mit einem Durchmesser von etwa 150 mm und einer Dicke von etwa 680 µm gebildet, was typischen Abmessungen eines Standardwafers entspricht.

Durch die Verwendung von Temperatur-resistenten Materialien für das Basiselement 1, weist der mobile Halter eine Eignung für hohe Umgebungstemperaturen auf, so daß der mobile Halter zum Halten von Prozesswafern während temperaturkritischer Prozessen, wie beispielsweise einem Legieren oder Sintern von Metallschichten, geeignet ist.

Silizium und andere Halbleitermaterialien zeigen bei hohen Temperaturen einen Anstieg der Eigenleitfähigkeit, die eine Verschlechterung der elektrostatischen Haltekraft bei den an die Elektroden angelegten Spannungen, die in dem Bereich von 1000 V bis 2000 V liegen, bewirkt. Als Material für die Verwendung bei Prozessen mit hoher Temperatur, wie beispielsweise Plasmaprozessen, sind für das Basiselement 1 Keramik und insbesondere SiC gegenüber Halbleitermaterialien bevorzugt, wobei SiC aufgrund der hohen Wärmeleitfähigkeit vorteilhafterweise zusätzlich eine gute Kühlung des zu haltenden Wafers sicherstellt. Ferner weist SiC den Vorteil auf, daß sich der Ausdehnungskoeffizient nicht wesentlich von demjenigen von Silizium unterscheidet, so daß insbesondere bei einem zu haltenden Wafer aus Silizium eine Verwendung von SiC als Material des Basiselements 1 vorteilhaft ist.

Der mobile Halter weist ferner eine funktionale Schicht 5 auf, die über der ersten Elektrode 3 und der zweiten Elektrode 4 und in den Zwischenräumen derselben angeordnet ist und sich als zusammenhängende Schicht über die ganze Fläche des Wafers erstreckt. Bei dem bevorzugten Ausführungsbeispiel besteht die funktionale Schicht 5 aus einem Material, das bewegliche Ionen enthält, wie beispielsweise Borsilikatglas, oder aus einem Material mit einer hohen Dielektrizitätskonstante, wie beispielsweise Bariumtitanat, Strontiumtitanat.

Über der elektrisch isolierenden Schicht 5 ist eine Abdekkung 6 aus einem isolierenden Material, wie beispielsweise Siliziumoxid oder Siliziumnitrid, ganzflächig gebildet. Die Abdeckung dient als ein Schutz vor aggressiven chemischen Substanzen für die darunter angeordnete funktionale Schicht 5.

Fig. 2 zeigt eine Draufsicht auf den in Fig. 1 gezeigten mobilen Halter, wobei Fig.1 und Fig.2 keinen einheitlichen Maßstab aufweisen. Wie in Fig. 2 zu erkennen ist, weist die erste Elektrode 3 einen ersten Anschlußbereich 7 und die zweite Elektrode 4 einen zweiten Anschlußbereich 8 auf, die jeweils in der Nähe der Kante des mobilen Halters angeordnet sind. Die Anschlussbereiche 7 und 8 ermöglichenein Anlegen einer elektrischen Spannung an die jeweils zugeordneten Elektroden. Die Anordnung der Anschlußbereiche in der Nähe der Kante des mobilen Halters ermöglicht, daß dieselben bei einer Anbringung eines Prozeßwafers freiliegend angeordnet werden können, indem der Prozeßwafer an dem mobilen Halter so angebracht wird, daß der Flat-Abschnitt des Wafers in dem Bereich der Anschlussbereiche liegt. Ein Flat-Abschnitt bezeichnet dabei einen Abschnitt, in dem die Kante des Wafers anstatt der Kreisbogenform einer geraden Linie eines Segmentabschnitts folgt, um die Richtung des Kristallwachstums anzuzeigen. Folglich können bei diesem Ausführungsbeispiel elektrische Zuleitungen für die Anschlussbereiche auf der Vorderseite des mobilen Halters befestigt werden.

Bei einem alternativen Ausführungsbeispiel sind Durchführungsleitungen für die erste Elektrode 3 und die zweite Elektrode 4 durch das Basiselement 1 durchgeführt, so daß die Elektroden durch Anschlussbereiche, die auf der Rückseite des Basiselements 1 gebildet sind, mit Anschlußleitungen elektrisch verbunden werden können. Die Durchführung der Anschlußleitung weist dabei den Vorteil auf, daß die Positionierung des Prozeßwafers unabhängig von der Position des Flats ist.

Bei dem in Fig. 2 gezeigten Ausführungsbeispiel sind die erste Elektrode 3 und die zweite Elektrode 4 ferner derart angeordnet, daß die Elektrode 3 im wesentlichen in einem ersten Viertel-Kreissegment der Kreisfläche des Basiselements 1 und einem demselben diagonal gegenüberliegenden zweiten Viertel-Kreissegment angeordnet ist, wobei die in den Viertel-Kreissegmenten angeordneten Elektrodenabschnitte über einen Steg verbunden sind, der sich durch den Mittelpunkt der Kreisfläche des Basiselements 1 erstreckt. Ferner ist die Elektrode 4 gemäß Fig. 2 im wesentlichen in den Viertel-Kreissegmenten, in denen die Elektrode 3 nicht angeordnet ist, gebildet. Die beiden diagonal entgegengesetzten Viertel-Kreissegment-Abschnitte der Elektrode 4 sind über einen länglichen, rundlich gebogenen Verbindungsbereich, der entlang der Kante des Basiselements 1 verläuft, miteinander verbunden.

Die erste Elektrode 3 und die zweite Elektrode 4 sind derart angeordnet, daß dieselben durch einen sich länglich erstreckenden Zwischenraum voneinander beabstandet sind, der im wesentlichen eine konstante Breite aufweist. Ferner sind die Elektroden 3 und 4 zu den Kanten des Basiselements 1 hin derart beabstandet, daß zwischen den Elektroden 3 und 4 und der Kante des Basiselements 1 ein Rand gebildet ist, der als eine Haltevorrichtung zum Anbringen des mobilen Halters an einem Träger verwendet werden kann.

Zum Anbringen eines zu haltenden Wafers, wie beispielsweise eines sehr dünnen Prozesswafers (20- 100 µm), muß der mobile Halter mit der Vorderseite in eine Berührung mit oder in eine unmittelbare Nähe zu der Seite des zu haltenden Wafers gebracht werden, an der der Halter angebracht werden soll.

Um den mobile Halter zu dem Aufnahmeort zu bewegen wird derselbe zunächst an einem Waferträger, wie beispielsweise einem Roboter-Waferträger, befestigt. Als Befestigungseinrichtung zum Befestigen des Waferträgers dient bei einem bevorzugten Ausführungsbeispiel der zwischen den Elektroden und der Kante des Wafers gebildete Rand, wobei bei diesem Ausführungsbeispiel der mobile Halter einen leicht größeren Durchmesser als der zu tragende Wafer aufweist, so daß der aufzunehmende Prozesswafer nicht in den Randbereich des mobilen Halters hineinragt und ohne eine Störung durch eine am Rand des mobilen Halters angebrachte Anbringungseinrichtung befestigt werden kann. Der mobile Halter kann dabei über einen Druckkontakt oder auf eine andere geeignete Weise, wie beispielsweise ein reversibles Kleben, an einer Anbringungseinrichtung des Waferträgers befestigt werden.

Bei einem weiteren Ausführungsbeispiel stellt die Kante des Basiselements 1 die Befestigungseinrichtung zum Anbringen des mobilen Halters an einem Waferträger dar. Bei diesem Ausführungsbeispiel wird der mobile Halter lediglich durch einen Druckkontakt einer Anbringungseinrichtung des Waferträgers mit der Kante des mobilen Halters gehalten.

Ferner kann bei einem weiteren Ausführungsbeispiel die Rückseite des mobilen Halters die Funktion einer Befestigungseinrichtung zum Anbringen eines Waferträgers aufweisen. Alternativ kann der mobile Halter auch an einen stationären Chuck, wie beispielsweise einen elektrostatischen Chuck, übergeben werden, wobei derselbe an der Rückseite des mobilen Halters befestigt wird.

Zur Erleichterung einer Übergabe des mobilen Halters kann derselbe ferner geeignete Justier- und Sensor-Elemente aufweisen.

Wie bereits erwähnt wurde, ist der mobile Halter in Form und Größe vorzugsweise derart ausgebildet, daß sich derselbe nur unwesentlich von einer standardisierten Form und Größe für Prozeßwafer unterscheidet, wobei selbst Wafer mit großem Durchmesser und geringer Dicke von dem mobilen Halter problemlos gehalten werden können. Die standardisierte Form des mobilen Halters ermöglicht, daß der mobile Halter in standardisierten Lagervorrichtungen für Wafer, wie beispielsweise Horden, gelagert werden kann und von denselben durch standardmäßige Waferträger, wie beispielsweise Roboter-Handhabungsvorrichtungen, aufgenommen und zu gewünschten Orten transportiert werden kann. Indem die bei der Halbleiterproduktion standardmäßig vorhandenen Halte- und Greif-Vorrichtungen verwendet werden können, stellt der erfindungsgemäße mobile Halter eine kostengünstiges System dar, das ferner ohne weiteres an einem beliebigen Typ eines Waferträgers angebracht werden kann, was eine Integration in einen Halbleiterherstellungsprozess wesentlich erleichtert.

Nachdem der mobile Halter an dem Waferträger befestigt ist, kann der mobile Halter mittels des Waferträgers zu dem zu haltenden Prozeßwafer bewegt werden.

Um ein Halten des zu haltenden Wafers an dem mobilen Halter zu ermöglichen, muß sich der mobile Halter in einem aktivierten Zustand befinden, bei dem an den Elektroden 3 und 4 jeweils entgegengesetzte Spannungen anliegen, die zum Befestigen eines Wafers ausreichend sind. Durch das Vorsehen der funktionalen Schicht 5 ist der mobile Halter ausgebildet, um einen aktivierten Zustand auch ohne eine äußere Spannungsquelle beizubehalten. Dies wird durch die Verwendung geeigneter Materialien für die funktionale Schicht 5 erreicht. Zur Verwendung der funktionalen Schicht 5 als eine Speicherschicht zum Speichern der elektrostatischen Ladungen in einem aktivierten Zustand wird als Material vorzugsweise ein dielektrisches Material mit beweglichen Ionen, wie beispielsweise Borsilikatglas, verwendet, das bewegliche Natrium- und Kaliumionen enthält. Alternativ kann ein Material mit einer hohen Dielektrizitätszahl verwendet werden.

Die Verwendung der obig genannten Materialien erlaubt eine quasi-permanente Ladungsverschiebung gemäß dem bekannten Kondensatoreffekt. Der mobile Halter wird lediglich zum Aufladen mit einer äußeren Spannungsquelle verbunden und weist auch nach dem Abtrennen der externen Spannungsquelle den aktivierten Zustand auf, bei dem zwischen der ersten Elektrode 3 und der zweiten Elektrode 4 eine zum Halten des Prozesswafers ausreichende Spannung anliegt. Bei längeren Haltezeiten kann der mobile Halter zum "Auffrischen" der Ladungen über die Anschlußbereiche 7, 8 mit der externen Spannungsquelle verbunden werden.

In dem aktivierten Zustand wird durch die entgegengesetzt aufgeladenen Elektroden 3 und 4 ein elektrisches Feld erzeugt, das in einem zu tragenden Wafer, der sich in Berührung mit der vorderen Seite des mobilen Halters oder in der unmittelbaren Nähe desselben befindet, eine Ladungsverschiebung verursacht, wodurch eine Kraft erzeugt wird, die den zu haltenden Wafer an der vorderen Seite des mobilen Halters hält. Je nach Feldverlauf werden dabei positive oder negative Ladungen auf der Oberfläche des zu tragenden Wafers erzeugt. Folglich weist ein Wafer, der an dem mobilen Halter gehalten wird, eine Oberflächenladungsverteilung auf, die im wesentlichen Bereiche mit positiver und negativer Ladung aufweist, die der Anordnung der Elektroden 3 und 4 entsprechen. Mit anderen Worten gesagt, erzeugt eine Elektrode 3 auf der Oberfläche eines zu haltenden Wafers in dem Bereich, der derselben gegenüberliegt, beispielsweise eine positive Ladung, wohingegen die Elektrode 4 auf der Oberfläche eines zu haltenden Wafers in dem Bereich, der derselben gegenüberliegt, eine negative Ladung erzeugt. Das Vorsehen der Elektroden 3 und 4 in Segmenten einer Kreisfläche weist folglich den Vorteil auf, daß durch ein Verbinden mit einer äußeren Spannungsquelle ein Umpolen oder ein Abschalten einer der beiden Elektrode ermöglicht wird, so daß eine Haltekraft reduziert und ausgeschaltet werden kann.

Besonders vorteilhaft kann der Waferhalter des obig beschriebenen Ausführungsbeispiel zur Vereinzelung von Chips in Verbindung mit einem Trockenätzen eingesetzt werden. Eine solche Verwendung ist nachfolgend erklärt.

Der Prozeßwafer wird dabei zunächst mit Gräben zur Vereinzelung der Chips an der Vorderseite des Prozeßwafers vorstrukturiert. Um die Ablösung von vereinzelten Chips zu ermöglichen, muß die Grabenstruktur der Anordnung der Elektroden entsprechen. Mit anderen Worten gesagt kann das obig beschriebene Ausführungsbeispiel eines mobilen Halters mit einer Elektrodenanordnung in Viertelkreis-Segmenten zur Vereinzelung eines Wafers in Viertelkreis-Segment-Chips verwendet, wobei die strukturierten Gräben den Wafer in Viertel-Kreissegmente aufteilen.

Die Tiefe der strukturierten Gräben wird entsprechend der gewünschten Restdicke des Wafers, die beispielsweise für Dünnschicht-Chips in dem Bereich von 40 bis 80 µm liegt, gewählt, die der Wafer nach einem Dünnungs- und Vereinzelungsprozess aufweisen soll.

Zum Herstellen von dünnen Chips wird der Dünnungsprozeß zunächst konventionell, beispielsweise mit einem Schleifen und Entspannungsätzen, bis zum Erreichen einer Dicke von etwa 100 µm durchgeführt. Die vorstrukturierten Gräben sind dabei noch geschlossen. Dannach wird der Wafer einem Dünnungsprozeß zugeführt, der beispielsweise in einer Vakuum-Plasmakammer durchgeführt wird. Dabei kann der Wafer entweder mit dem mobilen Halter oder einer bekannten Haltevorrichtung in die Plasmakammer transportiert werden und dort an einer stationären Haltevorrichtung, wie beispielsweise einem elektrostatischen Chuck, befestigt werden.

Alternativ kann der Wafer zur Durchführung der Dünnung in der Vakuum-Plasmakammer auch auf dem mobilen Halter verbleiben.

In der Plasmakammer wird der Wafer danach durch Trockenätzen der Rückseite auf die gewünschte Dicke von etwa 40 bis 80 µm gedünnt, wodurch die Gräben von der Rückseite her geöffnet werden. Durch das Öffnen der Gräben ist der Wafer automatisch in einzelne Chips vereinzelt. Danach wird der mobile Halter, der beispielsweise in einer Horde in der Vakuum-Plasmakammer aufbewahrt werden kann, an einem beweglichen Träger, wie beispielsweise einer Roboter-Handhabungsvorrichtung, angebracht. Das Anbringen an einem geeigneten Träger kann ohne weiteres durchgeführt werden, da der mobile Halter im wesentlichen die Form und Größe eines Wafers aufweist, wobei der Träger den Halter beispielsweise an der Kante oder dem Rand des Halters greift.

Der mobile Halter wird daraufhin mit der Vorderseite in die unmittelbare Nähe der vereinzelten Chips gebracht, so daß die Segment-Abschnitte der ersten Elektrode 3 und der zweiten Elektrode 4 den Chips jeweils gegenüberliegen. Zum genauen Ausrichten kann eine geeignete Justiervorrichtung verwendet werden. Ferner können auf dem mobilen Träger Sensoren vorgesehen sein, um eine exakte Justierung bezüglich der Chips zu ermöglichen.

Der stationäre elektrostatische Chuck gibt daraufhin die vereinzelten Chips frei, die darauffolgend von dem mobilen Halter aufgenommen werden. Der mobile Halter wird danach von dem beweglichen Träger zu einem Entladeort transportiert. An dem Entladeort werden die auf dem mobilen Halter angebrachten, vereinzelten Chips durch ein Umpolen der Elektrode 3 oder Elektrode 4 von dem mobilen Halter selektiv abgelöst.

Das Umpolen von Elektroden erfolgt über ein Anlegen einer Umpolspannung mit einer entgegengesetzten Polarität an den Anschlußbereich der jeweiligen Elektrode. Wird beispielsweise die Elektrode 3 umgepolt, so wird die Oberflächenladung in Chips, die der Elektrode 3 gegenüberliegen, abgebaut, wodurch sich die Haltekraft verringert und sich die jeweiligen Chips bei einem Erreichen einer unteren Haltekraft-Grenze von dem mobilen Halter ablösen.

Der etwa 100 µm dünne Wafer wird daraufhin an dem mobilen Halter derart befestigt, daß die Viertelkreis-Segmente des Wafers, die den zu vereinzelnden Chips entsprechen, den Viertelkreis-Segmenten der Elektroden 3 und 4 des mobilen Halters gegenüberliegen.

Bei dem beschriebenen Ausführungsbeispiel der Erfindung werden durch ein Umpolen einer der zwei Elektroden möglich, zwei der vier Viertelkreis-Segment-Chips selektiv abzulösen. Um für jeden der vier Viertelkreis-Segment-Chips ein selektives Ablösen zu ermöglichen, ist bei einem weiteren Ausführungsbeispiel eine Elektrodenstruktur von vier getrennten Viertelkreis-Segment-Elektroden vorgesehen, die jeweils einen Anschlußbereich zum Anlegen einer Spannung aufweisen. Zunächst werden die Chips durch eine geeignete Schaltung der Anschlußleitungen bei der Aktivierung entsprechend dem Ausführungsbeispiel von Fig. 2 aktiviert, so daß jeweils zwei diagonal gegenüberliegende Elektroden die gleiche Polarität aufweisen. Nach dem Aufnehmen kann durch ein gezieltes Umpolen der vier Viertelkreis-Segment-Elektroden wahlweise einer oder mehrere der Viertelkreis-Segment-Chips abgelöst werden, während die restlichen Viertelkreis-Segment-Chips weiterhin von dem mobilen Halter gehalten werden. Das Konzept von unabhängigen Elektroden, die bei dem obig beschriebenen Ausführungsbeispiel eine Elektrodenstruktur in einer 2 x 2 Matrixform bilden, kann bei einem weiteren Ausführungsbeispiel auf eine größere Anzahl von Elektroden erweitert werden, die in einer Matrix mit m Spalten und n Zeilen angeordnet sind.

Durch das Vorsehen der Elektrodenstruktur in Matrixform können einzelne Chips "pixelweise" abgenommen werden, indem die entsprechenden Elektroden der Matrix umgepolt werden. Der mobile Halter kann bei diesem Ausführungsbeispiel zum Vereinzeln einer Vielzahl von Chips aus einem Wafer eingesetzt werden.

Ferner kann der mobile Halter gemäß der vorliegenden Erfindung durch ein geeignetes Steuern der Anschlussspannungen verwendet werden, um vereinzelte Chips aus einer Mehrzahl von Chips selektiv aufzunehmen.

## Patentansprüche

1. Halter für einen Wafer mit folgenden Merkmalen:
einem Basiselement (1);
einer ersten Befestigungseinrichtung (3, 4, 5) zum elektrostatischen Anbringen des Wafers an dem Basiselement (1), die eine Elektrodenstruktur (3, 4) mit einer ersten Elektrode (3) und einer zweiten Elektrode (4) aufweist; und
einer zweiten Befestigungseinrichtung, dass die Elektrodenstruktur (3, 4) zwischen der funktionalen Schicht (5) und dem Basiselement (1) angeordnet ist, wobei die erste Elektrode (3) und die zweite Elektrode (4) jeweils einen Anschlussbereich (7, 8) zum Verbinden der Elektrodenstruktur mit elektrischen Anschlussleitungen aufweist,
dass die zweite Befestigungseinrichtung zum Anbringen des mobilen Halters an einem Waferträger ausgebildet ist,
**dadurch gekennzeichnet,**
**dass** der Halter ein mobiler Halter ist, und
**dass** die erste Befestigungseinrichtung eine funktionale Schicht (5), die eine Speicherschicht zum Speichern von elektrostatischen Ladungen umfasst, und eine elektrisch isolierende Schicht (6) auf der funktionalen Schicht aufweist, wobei der Wafer in Kontakt mit der isolierenden Schicht ist, wenn der Wafer an dem mobilen Halter angebracht ist.

2. Halter nach Anspruch 1, bei dem die Elektrodenstruktur (3, 4) mehr als zwei Elektroden aufweist.

3. Halter nach Anspruch 2, bei dem die mehr als zwei Elektroden in einer Matrix angeordnet sind.

4. Halter nach einem der Ansprüche 1 bis 4, bei dem die Anschlussbereiche (7, 8) an einem Bereich der ersten Befestigungseinrichtung angebracht ist, der einem Flat-Abschnitt eines durch den mobilen Halter gehaltenen Wafers entspricht.

5. Halter nach Anspruch 4, bei dem das Basiselement (1) eine Vorderseite und eine Rückseite aufweist, wobei auf der Vorderseite die erste Befestigungseinrichtung angeordnet ist, und wobei der Anschlussbereich (7, 8) auf der Vorderseite des Basiselements (1) angeordnet ist.

6. Halter nach Anspruch 1, bei dem das Basiselement (1) eine Vorderseite und eine Rückseite aufweist, wobei auf der Vorderseite die erste Befestigungseinrichtung angeordnet ist, und wobei der Anschlussbereich auf der Rückseite des Basiselements (1) angeordnet ist, wobei das Basiselement einen Durchgangsleiter aufweist, um den Anschlussbereich mit der Elektrodenstruktur (3, 4) zu verbinden.

7. Halter nach einem der Ansprüche 1 bis 6, bei dem die funktionale Schicht (5) aus Borsilikatglas, Bariumtitanat oder Strontiumtitanat besteht.

8. Halter nach einem der Ansprüche 1 bis 7, bei dem das Basiselement (1) aus einem Halbleitermaterial, Kapton oder Keramik besteht.

9. Halter nach Anspruch 1, bei dem das Basiselement (1) eine Vorderseite und eine Rückseite aufweist, wobei auf der Vorderseite die erste Befestigungseinrichtung angeordnet ist, und wobei die Rückseite des Basiselements als Fläche ausgebildet ist und die zweite Befestigungseinrichtung darstellt, so dass der mobile Halter an einem Vakuum-Chuck als Waferträger lösbar verbindbar ist.

10. Halter nach Anspruch 1, der einen Randbereich als zweite Befestigungseinrichtung aufweist, in den ein durch die erste Befestigungseinrichtung (3, 4, 5) gehaltener Wafer nicht hineinragt, wobei der Randbereich ausgebildet ist, um an dem Waferträger befestigt zu werden.

11. Halter nach Anspruch 1, bei dem das Basiselement (1) als zweite Befestigungseinrichtung eine Kante aufweist, die so ausgebildet ist, dass der mobile Halter lediglich mittels eines Druckkontakts zwischen dem Waferträger und der Kante durch den Waferträger lösbar anbringbar ist.

12. Halter nach Anspruch 1, der eine Vorderseite und eine Rückseite aufweist, wobei auf der Vorderseite der Wafer anbringbar ist, und wobei die Rückseite als zweite Befestigungseinrichtung ausgebildet ist, um an einem elektrostatischen Chuck als Waferträger befestigt zu werden.

13. Halte ach Anspruch 1, der so geformt ist, dass derselbe in Standardisierten Lagervorrichtungen für Wafer gelagert werden kann.

14. Verfahren zum Handhaben eines Wafers, mit folgenden Schritten:
Bereitstellen eines Halters für einen Wafer gemäß Anspruch 1;
Befestigen des Halters an einem Waferträger durch die zweite Befestigungseinrichtung des Halters;
Anbringen eines Wafers an dem Basiselement (1) des Halters mit der ersten Befestigungseinrichtung (3, 4, 5) des Halters;
Bewegen des Halters von einem ersten Ort zu einem zweiten Ort; und
Lösen des Wafers von dem Halter unter Betätigung der ersten Befestigungseinrichtung (3, 4, 5) des Halters.

## Claims

1. A holder for a wafer, comprising:
a base element (1);
a first fixing means (3, 4, 5) for electrostatically fixing the wafer to the base element (1), comprising an electrode structure (3, 4) comprising a first electrode (3) and a second electrode (4); and
a second fixing means, so that the electrode structure (3, 4) is arranged between the functional layer (5) and the base element (1), the first electrode (3) and the second electrode (4) each having a connecting area (7, 8) for connecting the electrode structure to electric leads,
that the second fixing means is implemented for fixing the mobile holder to a wafer support,
**characterized in that**
the holder is a mobile holder, and
the first fixing means comprises a functional layer (5) including a storage layer for storing electrostatic charges and an electrically insulating layer (6) on the functional layer, wherein the wafer is in contact with the insulating layer when the wafer is fixed to the mobile holder.

2. The holder according to claim 1, wherein the electrode structure (3, 4) comprises more than two electrodes.

3. The holder according to claim 2, wherein the more than two electrodes are arranged in a matrix.

4. The holder according to one of claims 1 to 4, wherein the connecting areas (7, 8) are fixed to an area of the first fixing means which corresponds to a flat section of a wafer held by the mobile holder.

5. The holder according to claim 4, wherein the base element (1) has a front face and a back, the front face having arranged thereon the first fixing means, and the connecting area (7, 8) being arranged on the front face of the base element (1).

6. The holder according to claim 1, wherein the base element (1) has a front face and a back, the front face having arranged thereon the first fixing means, and the back of said base element (1) having arranged thereon said connecting area, said base element comprising a feed-through lead for connecting the connecting area to the electrode structure (3, 4).

7. The holder according to one of claims 1 to 6, wherein the functional layer (5) consists of borosilicate glass, barium titanate or strontium titanate.

8. The holder according to one of claims 1 to 7, wherein the base element (1) consists of a semiconductor material, Kapton or ceramics.

9. The holder according to claim 1, wherein the base element (1) has a front face and a back, the front face having arranged thereon the first fixing means, and the back of the base element being implemented as an area and representing the second fixing means so that the mobile holder is adapted to be releasably connected to a vacuum chuck as a wafer support.

10. The holder according to claim 1, which comprises as a second fixing means a marginal area into which a wafer held by the first fixing means (3, 4, 5) does not project, said marginal area being implemented for fixing to the wafer support.

11. The holder according to claim 1, wherein the base element (1) comprises as a second fixing means an edge which is implemented such that the mobile holder is adapted to be releasably fixed by the wafer support simply by means of a pressure contact between the wafer support and said edge.

12. The holder according to claim 1, which comprises a front face and a back, the front face being adapted to have the wafer attached thereto, and the back being implemented as a second fixing means for fixing to an electrostatic chuck as a wafer support.

13. The holder according to claim 1, which has a shape of such a nature that it is adapted to be stored in standardized storage devices for wafers.

14. A method for handling a wafer, comprising the following steps:
providing a holder for a wafer according to claim 1;
fixing the holder to a wafer support with the aid of the second fixing means of the holder;
attaching a wafer to the base element (1) of the holder with the aid of the first fixing means (3, 4, 5) of the holder;
moving the holder from a first location to a second location; and
detaching the wafer from the holder by actuating the first fixing means (3, 4, 5) of the holder.

## Revendications

1. Support pour une plaquette, aux caractéristiques suivantes:
un élément de base (1);
un premier moyen de fixation (3, 4, 5) pour l'application électrostatique de la plaquette sur l'élément de base (1), laquelle présente une structure d'électrodes (3, 4) avec une première électrode (3) et une deuxième électrode (4); et
un deuxième moyen de fixation,
la structure d'électrodes (3, 4) étant disposée entre la couche fonctionnelle (5) et l'élément de base (1), la première électrode (3) et la deuxième électrode (4) présentant, chacune, une zone de raccordement (7, 8) destinée à connecter la structure d'électrodes à des lignes de raccordement électrique,
le deuxième moyen de fixation étant réalisé pour placer le support mobile sur un porte-plaquette,
**caractérisé par le fait**
**que** le support est un support mobile, et
**que** le premier moyen de fixation présente une couche fonctionnelle (5) comportant une couche d'accumulation destinée à accumuler des charges électrostatiques, et une couche d'isolation électrique (6) sur la couche fonctionnelle, la plaquette étant en contact avec la couche d'isolation lorsque la plaquette est placée sur le support mobile.

2. Support selon la revendication 1, dans lequel la structure d'électrodes (3, 4) présente plus de deux électrodes.

3. Support selon la revendication 2, dans lequel les plus de deux électrodes sont disposées dans une matrice.

4. Support selon l'une des revendications 1 à 4, dans lequel les zones de raccordement (7, 8) sont placées sur une zone du premier moyen de fixation qui correspond à un segment plat d'une plaquette maintenue par le support mobile.

5. Support selon la revendication 4, dans lequel l'élément de base (1) présente un côté avant et un côté arrière, sur le côté avant étant disposé le premier moyen de fixation, et la zone de raccordement (7, 8) étant disposée sur le côté avant de l'élément de base (1).

6. Support selon la revendication 1, dans lequel l'élément de base (1) présente un côté avant et un côté arrière, sur le côté avant étant disposé le premier moyen de fixation, et la zone de raccordement étant disposée sur le côté arrière de l'élément de base (1), l'élément de base présentant un conducteur de passage pour connecter la zone de raccordement à la structure d'électrodes (3, 4).

7. Support selon l'une des revendications 1 à 6, dans lequel la couche fonctionnelle (5) est réalisée en verre borosilicaté, en titanate de baryum ou en titanate de strontium.

8. Support selon l'une des revendications 1 à 7, dans lequel l'élément de base (1) est réalisé en un matériau semi-conducteur, en kapton ou en céramique.

9. Support selon la revendication 1, dans lequel l'élément de base (1) présente un côté avant et un côté arrière, sur le côté avant étant disposé le premier moyen de fixation, et le côté arrière de l'élément de base étant réalisé sous forme de face plane et représentant le deuxième moyen de fixation, de sorte que le support mobile puisse être connecté de manière amovible à un mandrin de serrage à vide comme porte-plaquette.

10. Support selon la revendication 1, présentant une zone de bordure comme deuxième moyen de fixation dans laquelle une plaquette maintenue par le premier moyen de fixation (3, 4, 5) ne penètre pas, la zone de bordure étant réalisée de manière à être fixée au porte-plaquette.

11. Support selon la revendication 1, dans lequel l'élément de base (1) présente, comme deuxième moyen de fixation, un bord qui est réalisé de sorte que le support mobile puisse être placé de manière amovible uniquement au moyen d'un contact par pression entre le porte-plaquette et le bord à travers le porte-plaquette.

12. Support selon la revendication 1, présentant un côté avant et un côté arrière, sur le côté avant pouvant être placée la plaquette, et le côté arrière étant réalisé comme deuxième moyen de fixation, pour être fixé à un mandrin de serrage électrostatique comme porte-plaquette.

13. Support selon la revendication 1, formé de sorte qu'il puisse être monté dans des dispositifs de montage standardisés pour plaquettes.

14. Procédé pour manipuler une plaquette, aux étapes suivantes consistant à:
préparer un support pour une plaquette selon la revendication 1;
fixer le support à un porte-plaquette par le deuxième moyen de fixation du support;
placer une plaquette sur l'élément de base (1) du support avec le premier moyen de fixation (3, 4, 5) du support;
déplacer le support d'un premier endroit à un deuxième endroit; et
libérer la plaquette du support en actionnant le premier moyen de fixation (3, 4, 5) du support.
